(19) Europäisches Patentamt
European Patent Office
Office européen des brevets

(11) **EP 1 826 911 A1**

(12) **EUROPÄISCHE PATENTANMELDUNG**

(43) Veröffentlichungstag:
**29.08.2007 Patentblatt 2007/35**

(51) Int Cl.:
*H03M 13/25* *(2006.01)*     *H03M 13/37* *(2006.01)*
*H03M 13/45* *(2006.01)*     *H03M 13/23* *(2006.01)*

(21) Anmeldenummer: **06004038.3**

(22) Anmeldetag: **28.02.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(71) Anmelder: **SIEMENS AKTIENGESELLSCHAFT 80333 München (DE)**

(72) Erfinder:
• **Bossert, Martin, Prof. Dr.**
  **89075 Ulm (DE)**
• **Hof, Axel**
  **73337 Unterböhringen (DE)**
• **Weckerle, Martin, Dr.**
  **89077 Ulm (DE)**

(54) **Codierung und Decodierung mit Trellis-codierter Modulation**

(57)     Die Erfindung betrifft ein Verfahren zur Codierung von Informationen, bei dem zu codierende Bits in aufeinanderfolgende erste Blöcke ($u_e^{(i)}$) aufgeteilt werden. Zweite Blöcke ($u_o^{(i)}$) werden jeweils durch Permutation eines ersten Blocks ($u_e^{(i)}$) ermittelt. Dritte Blöcke ($u_o^{(i)}$) werden ermittelt, indem jeweils ein erster Block ($u^{(i)}$) mit jeweils einem zweiten Block ($u_o^{(i)}$) verschachtelt wird. Die dritten Blöcke ($u^{(i)}$) werden jeweils faltungscodiert, und die Bits nach der Faltungscodierung werden zu Symbolen ($x^{(i)}$) zusammengefasst. Weiterhin betrifft die Erfindung ein Verfahren zur Decodierung und Vorrichtungen zur Durchführung der Verfahren.

## FIG 2

**Beschreibung**

Die Erfindung betrifft ein Verfahren zur Codierung von Informationen, ein Verfahren zum Decodieren dieser Informationen, sowie Vorrichtungen zur Durchführung der Verfahren.

Kommunikationssysteme dienen der Übertragung von Informationen zwischen einem Sender und einem Empfänger. In Funkkommunikationssystemen werden Informationen (beispielsweise Sprache, Bildinformation, Videoinformation, SMS (Short Message Service) oder andere Daten) mit Hilfe von elektromagnetischen Wellen über eine Funkschnittstelle zwischen Sender und Empfänger übertragen. Das Abstrahlen der elektromagnetischen Wellen erfolgt dabei mit Trägerfrequenzen, die in dem für das jeweilige System vorgesehenen Frequenzband liegen.

Nachrichtenkanäle, insbesondere Funkkanäle, sind einer Vielzahl von Störungen ausgesetzt. Unvermeidbar bei allen Systemen ist die Störung durch das Rauschen der Empfänger, meist additives weißes Gaußsches Rauschen. Weiterhin zeigen Funkkanäle viele zusätzliche Störungen, hervorgerufen durch Mehrwegeausbreitung, Streuung, Fading, Totalausfälle, Impulsstörungen, Interferenz von anderen Teilnehmern und Störsignalen.

Bei der digitalen Übertragung von Information über einen Kanal werden üblicherweise Verfahren der Kanalcodierung eingesetzt, um eine zuverlässige, weitestgehend fehlerfreie Übertragung zu gewährleisten. Bei dem Begriff Kanalcodierung handelt es sich um einen Oberbegriff für alle Codierverfahren, bei welchen die Eigenschaften eines Übertragungskanals berücksichtigt werden, um die Redundanz von zu übertragenden Daten gezielt zur Fehlererkennung bzw. Fehlerkorrektur zu erhöhen. Verfahren zur Kanalcodierung sind z.B. die Blockcodierung und die Faltungscodierung. Im Gegensatz hierzu reduziert die Quellencodierung die Redundanz.

Senderseitig findet im Codierer die Umwandlung von zu codierenden Bits in codierte Bits und eine Abbildung der codierten Bits in Symbole statt, welche dann über den Kanal zum Empfänger übertragen werden. Während der Übertragung werden die Symbole in der Regel durch Störeinflüsse verfälscht. Die Aufgabe des Decodierers auf der Empfängerseite besteht nun darin, eventuell aufgetretene Übertragungsfehler zu erkennen bzw. aus dem empfangenen, verfälschten Signal die gesendeten codierten Bits zu ermitteln.

Der Erfindung liegt die Aufgabe zugrunde, ein effizientes Verfahren zum Codieren und zum Decodieren von Informationen aufzuzeigen. Weiterhin sollen Vorrichtungen zur Durchführung der Verfahren vorgestellt werden.

Diese Aufgabe wird durch ein Verfahren mit den Merkmalen des Anspruchs 1, durch ein Verfahren mit Merkmalen eines nebengeordneten Anspruchs, sowie durch Vorrichtungen mit Merkmalen von nebengeordneten Ansprüchen gelöst. Vorteilhafte Ausgestaltungen und Weiterbildungen sind Gegenstand von Unteransprüchen.

Bei dem erfindungsgemäßen Verfahren zur Codierung von Informationen werden zu codierende Bits in aufeinanderfolgende erste Blöcke aufgeteilt. Zweite Blöcke werden ermittelt, und zwar jeweils durch Permutation eines ersten Blocks. Weiterhin werden dritte Blöcke ermittelt, indem jeweils ein erster Block mit jeweils einem zweiten Block verschachtelt wird. Die dritten Blöcke werden jeweils faltungscodiert. Die Bits nach der Faltungscodierung werden zu Symbolen zusammengefasst.

Die zu codierenden Informationen liegen in Form von Bits vor, welche in Blöcke aufgeteilt werden, in den Ansprüchen als erste Blöcke bezeichnet. Vorzugsweise werden die zu codierenden Bits vollständig in die ersten Blöcke aufgeteilt, so dass jedes Bit genau einem ersten Block zugeordnet ist. Aus den ersten Blöcken werden zweite Blöcke ermittelt, es besteht somit eine Abhängigkeit zwischen den ersten und den zweiten Blöcken. Bei der Berechnungsvorschrift zur Ermittlung der zweiten Blöcke handelt es sich zumindest auch um eine Permutation, d.h. um eine Vertauschung der Reihenfolge. Für die Zuordnung, welcher erste Block für die Ermittlung welches zweiten Blocks verwendet wird, existieren verschiedene Möglichkeiten. Vorzugsweise jedoch wird jeder erste Block zur Ermittlung genau eines zweiten Blocks eingesetzt.

Aus den ersten und den zweiten Blöcken werden dritte Blöcke ermittelt. Bei der Berechnungsvorschrift zur Ermittlung der dritten Blöcke handelt es sich zumindest auch um eine Verschachtelung. Dies bedeutet, dass sich in den dritten Blöcken nach einem bestimmten Muster Inhalte eines ersten und eines zweiten Blocks abwechseln. Die dritten Blöcke werden jeweils einer Faltungscodierung unterworfen. In den Eingang des Faltungscodierers wird somit ein dritter Block gegeben, und der Faltungscodierer gibt einen anderen Block von Bits aus, welcher in der Regel länger als der eingegebene dritte Block ist. Diese faltungscodierten Bits werden im Anschluss zu Symbolen zusammengefasst. Ein Symbol wird jeweils aus zumindest zwei Bits gebildet. Die Symbole stellen das Decodierergebnis dar, sie können z.B. an einen Decodierer gesendet werden.

In Ausgestaltung der Erfindung weisen alle ersten Blöcke die gleiche Länge auf. Zusätzlich ist es vorteilhaft, wenn auch die zweiten Blöcke diese Länge aufweisen. Betreffend die dritten Blöcke weisen diese vorzugsweise die zweifache Länge der ersten Blöcke auf.

In Weiterbildung der Erfindung bestehen die ersten Blöcke jeweils aus einem ganzzahligen Vielfachen von b-Tupeln von Bits mit b einer ganzen Zahl größer als 1, und die zweiten Blöcke werden jeweils durch Umordnung der Reihenfolge der b-Tupel eines ersten Blocks ermittelt. Wenn die Reihenfolge der b-Tupel vertauscht wird, bleibt hierbei die Reihenfolge der Bits innerhalb der einzelnen b-Tupel unverändert.

Besonders vorteilhaft ist es, wenn bei der Verschachtelung jeweils ein erster Block mit einem zweiten Block verschachtelt wird, wobei der jeweilige zweite Block aus dem direkt auf den jeweiligen ersten Block folgenden Block oder aus dem direkt vor dem jeweiligen ersten Block platzierten ersten Block durch Permutation ermittelt wird. Auf diese Weise enthält ein derart ermittelter dritter Block Inhalte eines ersten Blocks, sowie Inhalte eines weiteren ersten Blocks, welcher in Bezug auf die Reihenfolge der ersten Blöcke benachbart zu dem erstgenannten ersten Block ist.

In Weiterbildung der Erfindung bestehen die ersten und die zweiten Blöcke jeweils aus einem ganzzahligen Vielfachen von b-Tupeln von Bits mit b einer ganzen Zahl größer als 1, und aufgrund der Verschachtelung eines ersten und eines zweiten Blocks enthält der ermittelte dritte Block abwechselnd jeweils ein b-Tupel des ersten Blocks und ein b-Tupel des zweiten Blocks. Wenn die b-Tupel der Blöcke verschachtelt werden, bleibt hierbei die Reihenfolge der Bits innerhalb der einzelnen b-Tupel unverändert.

Einer Ausgestaltung der Erfindung gemäß liegt pro Block nach der Faltungscodierung und der Zusammenfassung zu Symbolen ein ganzzahliges Vielfaches von n-Tupeln von Symbolen mit n einer ganzen Zahl größer als oder gleich 1 vor, und lediglich jedes zweite n-Tupel wird als Codierergebnis verwendet. Die als Codierergebnis verwendeten n-Tupel werden vorzugsweise an einen Decodierer gesendet. Die nicht als Codierergebnis verwendeten n-Tupel können verworfen werden. Vorzugsweise entsprechen die als Codierergebnis verwendeten n-Tupel den ersten Blöcken.

Bei dem erfindungsgemäßen Verfahren zum Decodieren von Informationen, welche nach dem erfindungsgemäßen Verfahren codiert wurden, wird ein iterativer Decodier-Algorithnus verwendet, bei welchem für einen Block bestimmte Zuverlässigkeitswerte für die wiederholte Bestimmung von Zuverlässigkeitswerten eines anderen Blocks verwendet werden. Bei den Zuverlässigkeitswerten handelt es sich um so genannte soft-output-Werte eines Decodierverfahrens. Aus ihnen kann bestimmt werden, welche Werte dem Codierer wahrscheinlich in Bezug auf bestimmte vom Decodierer empfangene Informationen vorlagen. Dass Zuverlässigkeitswerte für einen Block wiederholt bestimmt werden, bedeutet, dass Zuverlässigkeitswerte für den betreffenden Block zuvor bereits bestimmt wurden. Eine wiederholte Bestimmung kann das Ergebnis, d.h. die Werte der bestimmten Zuverlässigkeitswerte, verbessern.

Insbesondere können zur Decodierung Zuverlässigkeitswerte für einen empfangenen Block bestimmt werden und im Anschluss unter Verwendung dieser Zuverlässigkeitswerte wiederholt Zuverlässigkeitswerte für einen zuvor empfangenen Block bestimmt werden. Zusätzlich oder alternativ können zur Decodierung Zuverlässigkeitswerte für einen empfangenen Block bestimmt werden und im Anschluss unter Verwendung dieser Zuverlässigkeitswerte wiederholt Zuverlässigkeitswerte für einen danach empfangenen Block bestimmt werden.

Besonders vorteilhaft ist es, wenn die Zuverlässigkeitswerte permutiert werden, bevor sie für die wiederholte Bestimmung von Zuverlässigkeitswerten verwendet werden. Diese Permutation kann insbesondere auf die während dem Codiervorgang verwendete Permutation abgestimmt sein, indem sie dieser gleich ist oder ihrem Umkehrvorgang entspricht.

In Ausgestaltung der Erfindung werden zur Decodierung eines empfangenen Blocks $2 \cdot w - 1$ mal Zuverlässigkeitswerte für diesen Block bestimmt, mit w einer ganzen Zahl größer als 1, wobei das Ergebnis der $2 \cdot w - 1$ -ten Bestimmung als Decodierergebnis für diesen Block verwendet wird. Das Decodierergebnis dient dazu, die abschließende Entscheidung darüber zu treffen, welche Werte dem Codierer wahrscheinlich in Bezug auf bestimmte vom Decodierer empfangene Informationen vorlagen.

Die erfindungsgemäße Codiervorrichtung zur Codierung von Informationen weist Mittel auf zum Aufteilen von zu codierenden Bits in aufeinanderfolgende erste Blöcke, Mittel zum Ermitteln von zweiten Blöcken jeweils durch Permutation eines ersten Blocks, Mittel zum Ermitteln von dritten Blöcken, indem jeweils ein erster Block mit jeweils einem zweiten Block verschachtelt wird, Mittel zum Anwenden einer Faltungscodierung auf die dritten Blöcke, und Mittel zum Zusammenfassen der Bits nach der Faltungscodierung zu Symbolen.

Mit Vorzug liegt pro erstem Block nach der Faltungscodierung und der Zusammenfassung zu Symbolen ein ganzzahliges Vielfaches von n-Tupeln von Symbolen mit n einer ganzen Zahl größer als oder gleich 1 vor, und die Codiervorrichtung umfasst ferner Mittel zum Ausscheiden von jedem zweiten n-Tupel, so dass lediglich jedes zweite n-Tupel als Codierergebnis verwendet wird.

Die erfindungsgemäße Decodiervorrichtung umfasst Mittel zum Empfangen und Decodieren von gemäß der erfindungsgemäßen Codierung codierten Informationen, umfassend Mittel zum Bestimmen von Zuverlässigkeitswerten für empfangene Blöcke unter Verwendung eines iterativen Decodier-Algorithmus, bei welchem für einen Block bestimmte Zuverlässigkeitswerte für die wiederholte Bestimmung von Zuverlässigkeitswerten eines anderen Blocks verwendet werden.

Die erfindungsgemäßen Vorrichtungen eignen sich insbesondere zur Durchführung der erfindungsgemäßen Verfahren, wobei dies auch auf die Ausgestaltungen und Weiterbildungen zutreffen kann. Hierzu können sie weitere geeignete Mittel umfassen. Die erfindungsgemäßen Vorrichtungen können durch mehrere miteinander verbundene Einzelvorrichtungen realisiert werden. Insbesondere ist es möglich, dass die erfindungsgemäße Codiervorrichtung und die erfindungsgemäße Decodiervorrichtung Bestandteil der gleichen Gesamtvorrichtung sind.

Im folgenden wird die Erfindung anhand eines Ausführungsbeispiels näher erläutert. Dabei zeigen:

Figur 1:   schematisch einen TCM Codierer,

Figur 2:   schematisch einen erfindungsgemäßen Codierer,

Figur 3:   schematisch einen erfindungsgemäßen Decodierer.

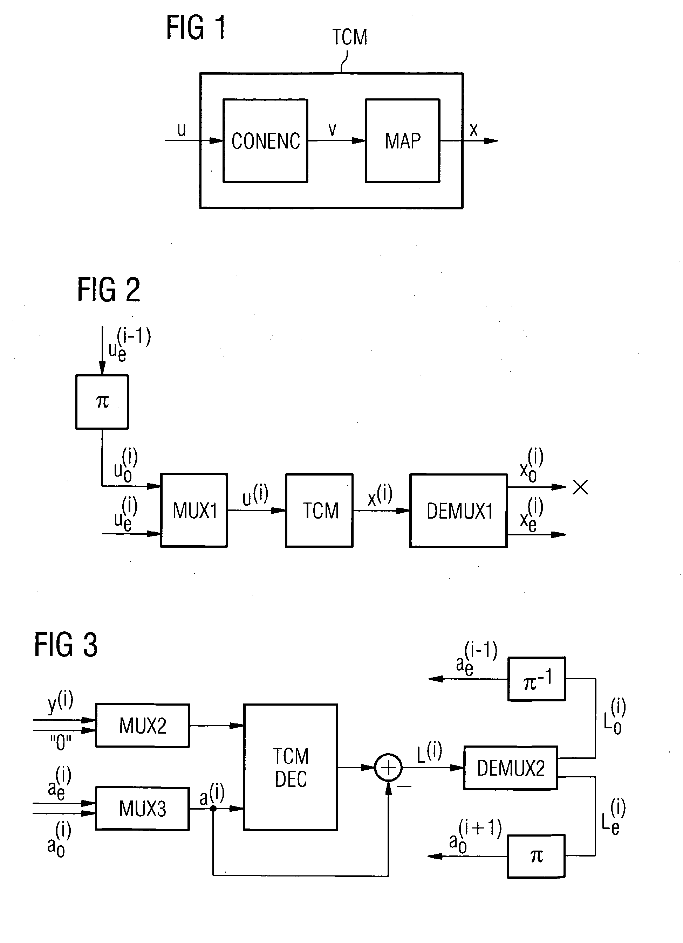

Das folgende Ausführungsbeispiel betrifft die Codierung von Bits vor der Versendung per Funk in einem Mobilfunkkommunikationssystem. Die Kanalcodierung fügt den zu codierenden Bits Redundanz zu. Dies erfolgt, um die verfälschenden Einflüsse des Funkkanals während der Funkübertragung zu reduzieren. Ein Beispiel für ein Verfahren zur Kanalcodierung ist die Trellis-Codierte Modulation (TCM). Figur 1 zeigt einen TCM Codierer TCM, beschrieben z.B. in
G. Ungerboeck: "Channel coding with multilevel phase signals", IEEE Transactions on Information Theory, vol. 28, pp. 55-67, January 1982.

Der TCM-Codierer TCM umfasst einen binären Faltungscodierer CONENC und einen Mapper MAP zum Abbilden von Bits auf Symbole. Der Faltungscodierer CONENC wird meist durch eine digitale Schaltung aus Schieberegistern realisiert, deren Inhalte auf verschiedene Arten zusammen mit den aktuell eingehenden Bits durch Addition und Modulo-2-Operationen verknüpft werden. Bei u handelt es sich um einen Block aus b Bits. Diese b Bits werden durch den Faltungscodierer CONENC in den Block v, welcher aus c Bits besteht, umgewandelt. Die Rate des Faltungscodes ist somit b/c. Das c-Tupel von Bits v geht in den Mapper MAP ein, wo jeweils q Bits zu einem Symbol zusammengefasst werden. Hierbei wird davon ausgegangen, dass c ein ganzzahliges Vielfaches von q ist. Somit besteht der ausgegebene Symbolblock x aus $n = \dfrac{c}{q}$ Symbolen.

Ein Vorteil der TCM-Codierung liegt darin, dass man unter Verwendung der TCM-Codierung näher an die Shannon-Grenze gelangen kann als beispielsweise bei herkömmlicher Codierung mit bit-interleavter Modulation. Denn bei der TCM-Codierung wird nicht die Hamming-Distanz maximiert, sondern der Abstand zwischen Symbolen im euklidischen Raum.

Figur 2 zeigt einen erfindungsgemäßen Codierer. Hierbei ist $u_e^{(i)}$ ein Block von $N \cdot b$ Bits, welcher in einer Zeitspanne i in den Codierer eingegeben wird. Bei der Zeitspanne i handelt es sich ungefähr um die Zeit, welche der Codierer benötigt, um $2 \cdot N \cdot b$ Bits zu verarbeiten. In der darauffolgenden Zeitspanne (i+1) wird der nächste Block $u_e^{(i+1)}$ in den Codierer gegeben. Bei N handelt es sich um eine ganze Zahl, b ist die oben in Bezug auf den TCM-Codierer erläuterte Tupelgröße, welche von dem Faltungscodierer des TCM-Codierers TCM verarbeitet wird. $u_e^{(i)}$ beinhaltet somit N b-Tupel von Bits.

Auch $u_o^{(i)}$ ist ein Block von $N \cdot b$ Bits, welcher in der gleichen Zeitspanne i wie der Block $u_e^{(i)}$ in den Codierer eingeht. Der Multiplexer MUX1 ordnet die Bits der Blöcke $u_e^{(i)}$ und $u_o^{(i)}$ derart an, dass zuerst das erste b-Tupel des Blocks $u_e^{(i)}$, dann das erste b-Tupel des Blocks $u_o^{(i)}$, dann das zweite b-Tupel des Blocks $u_e^{(i)}$, dann das zweite b-Tupel des Blocks $u_o^{(i)}$ usw. steht. Die Reihenfolge der Bits innerhalb der b-Tupel der Blöcke $u_e^{(i)}$ und $u_o^{(i)}$ wird hierbei nicht verändert, es werden lediglich die b-Tupel der Blöcke $u_e^{(i)}$ und $u_o^{(i)}$ auf die beschriebene Weise ineinander verschachtelt.

Bei den Blöcken $u_e^{(i)}$ handelt es sich um die tatsächlich zu codierenden Bits. Die Bits des Blockes $u_o^{(i)}$ hingegen werden aus den Bits des Blockes $u_e^{(i-1)}$ der vorhergehenden Zeitspanne (i-1) bestimmt. Für diese Bestimmung wird der Permutierer π eingesetzt. Dieser ändert die Reihenfolge der b-Tupel des Blocks $u_e^{(i-1)}$, wobei die Reihenfolge der Bits innerhalb eines jeden b-Tupels des Blocks $u_e^{(i-1)}$ gleich bleibt. Es gilt daher

$$u_o^{(i)} = \pi(u_e^{(i-1)})\,,$$ wobei π( ) die Anwendung der Permutationsfunktion auf den Inhalt der Klammer bedeutet. Die Bits eines jeden Blocks $u_e^{(i)}$ werden somit zwei mal in den Codierer eingegeben: ein erstes Mal in ihrer ursprünglichen Reihenfolge und ein zweites Mal mit einer durch den Permutierer π vertauschten Reihenfolge der b-Tupel.

Für die erste Zeitspanne i=1 wird für den Block $u_o^{(1)}$ ein Block der Länge $N \cdot b$ bestehend aus ausschließlich Nullen verwendet. Dieses kann als a-priori-Wissen bei der Decodierung eingesetzt werden, wie später in Bezug auf Figur 3 erläutert wird.

Der Multiplexer MUX1 gibt einen Block $u^{(i)}$ aus, welcher aus $2 \cdot N \cdot b$ Bits besteht, denn die Blöcke $u_e^{(i)}$ und $u_o^{(i)}$ der Länge $N \cdot b$ Bits wurden durch den Multiplexer MUX1 ineinander verschachtelt. Da der Block $u_o^{(i+1)}$ bis auf die Reihenfolge der b-Tupel mit dem Block $u_e^{(i)}$ übereinstimmt, besteht eine Abhängigkeit zwischen den Blöcken $u^{(i)}$ und $u^{(i+1)}$.

Die Blöcke $u^{(i)}$ werden von dem TCM-Codierer TCM in an sich bekannter Weise codiert. Den TCM-Codierer TCM verlassen die Blöcke $x^{(i)}$, welche jeweils aus $2 \cdot N \cdot n$ Symbolen bestehen. Denn wie in Bezug auf Figur 1 erläutert, verlässt den TCM-Codierer TCM pro b-Tupel eingehender Bits ein Symbolblock aus $n = \dfrac{c}{q}$

Symbolen. In den TCM-Codierer TCM werden pro Zeitspanne i $2 \cdot \overline{N}$ b-Tupel eingegeben, denn die beiden Blöcke $u_e^{(i)}$ und $u_o^{(i)}$ bestehen jeweils aus N b-Tupeln.

Wie bereits erwähnt handelt es sich bei den Blöcken $u_e^{(i)}$ um die zu codierenden Bits, während die Blöcke $u_o^{(i)}$ lediglich aus den zu codierenden Bits ermittelt und diesen durch die Verschachtelung im Multiplexer MUX1 zugefügt wurden. Daher liegen am Ausgang des TCM-Codierers TCM doppelt so viele Symbole vor, als bei einer herkömmlichen TCM-Codierung der Blöcke $u_e^{(i)}$ vorhanden wären. Dies würde zu einer Halbierung der Nutzdatenrate führen. Um dies zu vermeiden, wird der Demultiplexer DEMUX1 eingesetzt. Dieser halbiert die Anzahl der Symbole der Blöcke $x^{(i)}$, indem jeweils ein n-Tupel dem Block $x_e^{(i)}$ und ein n-Tupel dem Block $x_o^{(i)}$ zugeordnet wird. Der Block $x_e^{(i)}$ besteht somit aus dem ersten, dem dritten, dem fünften usw. n-Tupel von Symbolen des Blockes $x^{(i)}$. Entsprechend besteht der Block $x_o^{(i)}$ aus dem zweiten, dem vierten, dem sechsten usw. n-Tupel von Symbolen des Blockes $x^{(i)}$. Die beiden Blöcke $x_e^{(i)}$ und $x_o^{(i)}$ beinhalten jeweils $N \cdot n$ Symbole.

Für jeden Block $u_e^{(i)}$ mit $N \cdot b$ Bits wird ein Block $x_e^{(i)}$ mit $N \cdot n$ Symbolen als Codierergebnis verwendet und an einen Decodierer übertragen. Bei idealer Nyquist Pulsformung liegt somit eine Bandbreiten-Effizienz von

$$\eta = \frac{b}{n}$$ Bits/Symbol vor. Dies entspricht der Bandbreiten-Effizienz, welche bei einer herkömmlichen TCM-Codierung vorhanden wäre.

Die Symbole der Blöcke $x_o^{(i)}$ werden verworfen, durch ein Kreuz symbolisiert, während die Symbole der Blöcke $x_e^{(i)}$ versendet werden. Die Blöcke $x_e^{(i)}$ können direkt den Blöcken $u_e^{(i)}$ zugeordnet werden. Die tatsächlichen Symbole, welche in den Blöcken $x_e^{(i)}$ enthalten sind, hängen jedoch von den Werten der Bits der Blöcke $u_o^{(i)}$ ab, denn diese beeinflussen den Zustand des Faltungscodierers des TCM-Codierers TCM. Somit beeinflusst jeder Block $u_e^{(i-1)}$ das Codierergebnis $x_e^{(i)}$ des jeweils nachfolgenden Blockes $u_e^{(i)}$.

Figur 3 zeigt den Aufbau eines Decodierers zur Decodierung der von einem Codierer gemäß Figur 2 codierten Bits. Empfangen wird ein Block $y^{(i)}$, bestehend aus der Überlagerung der $N \cdot n$ Symbole eines Blocks $x_e^{(i)}$ mit dem Rauschen des Funkkanals. Die empfangenen Blöcke $y^{(i)}$ mit jeweils $N \cdot n$ Symbolen werden durch den Multiplexer MUX2 mit Auslöschungen, in Figur 3 durch "0" symbolisiert, verschachtelt. Hierdurch wird berücksichtigt, dass die Blöcke $x_o^{(i)}$ verworfen wurden. Dem TCM-Decodierer TCM DEC wird somit von dem Multiplexer MUX2 abwechselnd ein n-Tupel von Symbolen aus dem Block $y^{(i)}$ und ein n-Tupel von Auslöschungen zugeführt.

Da der Decodierer kein a-priori-Wissen über die Blöcke $u_e^{(i)}$ hat, welche als Blöcke $x_e^{(i)}$ gesendet und als Blöcke $y^{(i)}$ empfangen werden, werden die für die TCM-Decodierung benötigten Werte der Wahrscheinlichkeitsmatrix $a_e^{(i)}$ zu Beginn auf $-b \cdot \log 2$ gesetzt.

Hingegen liegt a-priori-Information über die Blöcke $u_o^{(i)}$ vor, und zwar aus der Decodierung des zuvor empfangenen Blocks, da die in der Reihenfolge vertauschte Version von $u_o^{(i)}$ als $u_e^{(i-1)}$ gesendet und als $y^{(i-1)}$ empfangen wurde. Durch den Multiplexer MUX3 werden die Spalten der Matrizen $a_e^{(i)}$ und $a_o^{(i)}$ gemultiplext. Die resultierende Matrix $a^{(i)}$ wird von dem TCM-Decodierer TCM DEC als a-priori-Information verwendet. Der TCM-Decodierer TCM DEC berechnet auf von der herkömmlichen TCM-Decodierung bekannte Weise Soft-Output-Werte, d.h. Zuverlässigkeitswerte für die in $u^{(i)}$ enthaltenen b-Tupel von Bits auf Basis der empfangenen Blöcke $y^{(i)}$. Die nichtbinäre TCM-Decodierung wird beschrieben z.B. in:

P. Robertson and T. Woerz: "Bandwidth-efficient turbo trellis-coded modulation using punctured component codes", IEEE Journal on Selected Areas in Communications, vol. 18, pp. 206-218, Februar 1998.
H. Ogiwara and M. Yano: "Improvement of Turbo Trellis-Coded Modulation System", IEICE Trans. Fundamentals, vol. E81-A, no. 10, pp. 2040-2046, Oktober 1998.

Von dem Ergebnis der Decodierung durch den TCM-Decoder TCM DEC wird die a-priori-Information $a^{(i)}$ abgezogen, es resultiert die $2^b \times 2N$ Matrix $L^{(i)}$ von Zuverlässigkeitswerten. Diese wird durch den Demultiplexer DEMUX2 analog zu $u^{(i)}$ und $x^{(i)}$ in die beiden Matrizen $L_e^{(i)}$ und $L_o^{(i)}$ der Dimension $2^b \times N$ aufgeteilt, indem abwechselnd eine Spalte der Matrix $L^{(i)}$ der Matrix $L_e^{(i)}$ und die nächste Spalte der Matrix $L_o^{(i)}$ zugeordnet wird.

Die beschriebene Vorgehensweise ist der erste Schritt in einem iterativen Decodier-Algorithmus. Das vollständige, mehrere Iterationsschritte umfassende Verfahren erfolgt folgendermaßen: nachdem $y^{(i)}$ decodiert wurde, kann der vorhergehende Block $y^{(i-1)}$ erneut decodiert werden, und zwar unter Verwendung von $L_o^{(i)}$. Hierbei wird eine verbesserte Version von $a_e^{(i-1)}$ eingesetzt, und zwar $a_e^{(i-1)} = \pi^{-1}(L_o^{(i)})$. Hierbei entspricht $\pi^{-1}$ der Umkehroperation der Permutation $\pi$ von Figur 2. Auf diese Weise können alle zuvor empfangenen Blöcke $y^{(i')}$ mit $i' < i$ erneut decodiert werden, jeweils mit verbesserter a-priori-Information

$$a_e^{(i')} = \pi^{-1}(L_o^{(i'+1)}).$$

Die Anzahl der $y^{(i')}$, welche erneut decodiert werden, entspricht w-1. Dadurch ergibt sich ein Fenster der Größe w mit w einer ganzen Zahl größer 1. Wenn das Ende des Fensters erreicht ist wird der zeitlich im Fenster als erstes liegende Block $y^{(i-w+1)}$ decodiert. Durch die Decodierung von $y^{(i-w+1)}$ erhält man eine verbesserte a-priori-Information $L_e^{(i-w+1)}$, korrespondierend zu dem Block $u_e^{(i-w+1)}$. Diese kann zur Decodierung des Blocks $y^{(i-w+2)}$ verwendet werden, und zwar unter Verwendung von $a_o^{(i-w+2)} = \pi(L_e^{(i-w+1)})$. Hierbei entspricht $\pi$ der Permutation $\pi$ von Figur 2. Auf diese Weise wird die Decodierung bis zum Block $y^{(i)}$ durchgeführt, wobei erneut $L^{(i)}$ unter Verwendung von

$$a_o^{(i)} = \pi\left(L_e^{(i-1)}\right)$$ bestimmt wird. Hiermit ist das iterative Decodierverfahren abgeschlossen.

Zusammenfassend verläuft das beschriebene iterative Decodierverfahren somit folgendermaßen: es wird gestartet mit der Decodierung eines empfangenen Blockes $y^{(i)}$. Ausgehend von diesen Zuverlässigkeitswerten werden die Zuverlässigkeitswerte der Blöcke zurück bis zum Block $y^{(i-w+1)}$ bestimmt, und im Anschluss ausgehend von diesen Zuverlässigkeitswerten des Blocks $y^{(i-w+1)}$ die Zuverlässigkeitswerte der Blöcke vorwärts bis zum Block $y^{(i)}$.

Als konkretes Beispiel wird w=4 betrachtet. Es werde der Block $y^{(6)}$ zum ersten Mal decodiert. Dann werden die zuvor empfangenen Blöcke $y^{(5)}$, $y^{(4)}$, und $y^{(3)}$ erneut decodiert, jeweils unter Verwendung des Ergebnisses des Blockes mit der um 1 höheren Nummer. Im Anschluss werden die Blöcke $y^{(4)}$, $y^{(5)}$ und $y^{(6)}$ erneut decodiert, jeweils unter Verwendung des Ergebnisses des Blockes mit der um 1 niedrigeren Nummer. Die zuletzt für den Block $y^{(3)}$ bestimmten Zuverlässigkeitswerte sind das endgültige Decodierergebnis für den Block $y^{(3)}$. Nun wird der Block $y^{(7)}$ zum ersten Mal decodiert. Das Decodierfenster mit der Tiefe w=4 wird nun um eine Stelle verschoben und die in Bezug auf den Block $y^{(6)}$ erläuterte Bestimmung erfolgt nun in Bezug auf den Block $y^{(7)}$ und das endgültige Ergebnis für den Block $y^{(4)}$ wird in dieser Iteration bestimmt.

Jeder Block $y^{(i)}$ mit Ausnahme des Blockes $y^{(1)}$ wird 2w-1 mal decodiert, bevor das endgültige Decodierergebnis ermittelt ist. Der erste Block $y^{(1)}$ wird lediglich w mal decodiert. Für diesen ersten Block $y^{(1)}$ besteht jedoch der Vorteil, dass absolut zuverlässige a-priori-Information für $u_o^{(1)}$ zur Verfügung steht. Wie oben erwähnt, handelt es sich bei den Bits von $u_o^{(1)}$ ausschließlich um Nullen.

Durch die Verwendung des beschriebenen iterativen Decodier-Algorithmus, welcher durch die anhand von Figur 2 beschriebene Codierung ermöglicht wird, kann die Bit-Fehlerrate deutlich reduziert werden. Diese Reduktion nimmt mit zunehmender Fenstergröße w zu. Jedoch steigert sich mit zunehmender Fenstergröße auch der Decodieraufwand. Die Reduktion der Bit-Fehlerrate wird dadurch bewirkt, dass eine Abhängigkeit zwischen benachbarten Symbol-Blöcken, welche der Codierer ausgibt, besteht. Auf diese Weise kann gegebenenfalls ein Block, welcher durch die Übertragung stark verrauscht ist, dennoch vom Decodierer korrekt decodiert werden, da die Decodierergebnisse von zuvor und danach empfangenen Blöcken in die Decodierung des verrauschten Blockes einbezogen werden.

**Patentansprüche**

1. Verfahren zur Codierung von Informationen, bei dem zu codierende Bits in aufeinanderfolgende erste Blöcke ($u_e^{(i)}$) aufgeteilt werden,

zweite Blöcke ($u_o^{(i)}$) jeweils durch Permutation eines ersten Blocks ($u_e^{(i)}$) ermittelt werden,
dritte Blöcke ($u^{(i)}$) ermittelt werden, indem jeweils ein erster Block ($u_e^{(i)}$) mit jeweils einem zweiten Block ($u_o^{(i)}$) verschachtelt wird,
die dritten Blöcke ($u^{(i)}$) jeweils faltungscodiert werden, und die Bits nach der Faltungscodierung zu Symbolen ($x^{(i)}$) zusammengefasst werden.

2. Verfahren nach Anspruch 1, bei dem
alle ersten Blöcke ($u_e^{(i)}$) die gleiche Länge aufweisen.

3. Verfahren nach Anspruch 2, bei dem
die zweiten Blöcke ($u_o^{(i)}$) die gleiche Länge aufweisen wie die ersten Blöcke ($u_e^{(i)}$).

4. Verfahren nach einem der Ansprüche 2 oder 3, bei dem
die dritten Blöcke ($u^{(i)}$) die doppelte Länge der ersten Blöcke ($u_e^{(i)}$) aufweisen.

5. Verfahren nach einem der Ansprüche 1 bis 4, bei dem
die ersten Blöcke ($u_e^{(i)}$) jeweils aus einem ganzzahligen Vielfachen von b-Tupeln von Bits mit b einer ganzen Zahl größer als 1 bestehen, und
die zweiten Blöcke ($u_o^{(i)}$) jeweils durch Umordnung der Reihenfolge der b-Tupel eines ersten Blockes ($u_e^{(i)}$) ermittelt werden.

6. Verfahren nach einem der Ansprüche 1 bis 5, bei dem
bei der Verschachtelung jeweils ein erster Block ($u_e^{(i)}$) mit einem zweiten Block ($u_o^{(i)}$) verschachtelt wird, wobei der jeweilige zweite Block ($u_o^{(i)}$) aus dem direkt auf den jeweiligen ersten Block ($u_e^{(i)}$) folgenden ersten Block oder aus dem direkt vor dem jeweiligen ersten Block ($u_e^{(i)}$) platzierten ersten Block ($u_e^{(i-1)}$) durch Permutation ermittelt wird.

7. Verfahren nach einem der Ansprüche 1 bis 6, bei dem
die ersten ($u_e^{(i)}$) und die zweiten ($u_o^{(i)}$) Blöcke jeweils aus einem ganzzahligen Vielfachen von b-Tupeln von Bits mit b einer ganzen Zahl größer als 1 bestehen, und aufgrund der Verschachtelung eines ersten ($u_e^{(i)}$) und eines zweiten ($u_o^{(i)}$) Blockes der ermittelte dritte Block ($u^{(i)}$) abwechselnd jeweils ein b-Tupel des ersten Blocks ($u_e^{(i)}$) und ein b-Tupel des zweiten Blocks ($u_o^{(i)}$) enthält.

8. Verfahren nach einem der Ansprüche 1 bis 7, bei dem
pro erstem Block ($u_e^{(i)}$) nach der Faltungscodierung und der Zusammenfassung zu Symbolen ($x^{(i)}$) ein ganzzahliges Vielfaches von n-Tupeln von Symbolen ($x^{(i)}$) mit n einer ganzen Zahl größer als oder gleich 1 vorliegt, und
lediglich jedes zweite n-Tupel als Codierergebnis verwendet wird.

9. Verfahren nach Anspruch 8, bei dem
die als Codierergebnis verwendeten n-Tupel den codierten ersten Blöcken ($u_e^{(i)}$) entsprechen.

10. Verfahren zum Decodieren von nach einem der Ansprüche 1 bis 9 codierten Informationen,
bei welchem ein iterativer Decodier-Algorithmus verwendet wird, bei welchem für einen Block bestimmte Zuverlässigkeitswerte ($L^{(i)}$) für die wiederholte Bestimmung von Zuverlässigkeitswerten ($L^{(i)}$) eines anderen Blocks verwendet werden.

11. Verfahren nach Anspruch 10, bei dem
zur Decodierung Zuverlässigkeitswerte ($L^{(i)}$) für einen empfangenen Block bestimmt werden und im Anschluss unter Verwendung dieser Zuverlässigkeitswerte ($L^{(i)}$) wiederholt Zuverlässigkeitswerte für einen zuvor empfangenen Block bestimmt werden.

12. Verfahren nach Anspruch 10 oder 11, bei dem
zur Decodierung Zuverlässigkeitswerte ($L^{(i)}$) für einen empfangenen Block bestimmt werden und im Anschluss unter Verwendung dieser Zuverlässigkeitswerte ($L^{(i)}$) wiederholt Zuverlässigkeitswerte für einen danach empfangenen Block bestimmt werden.

13. Verfahren nach Anspruch 11 oder 12, bei dem
die Zuverlässigkeitswerte ($L^{(i)}$) permutiert werden, bevor sie für die wiederholte Bestimmung von Zuverlässigkeitswerten ($L^{(i)}$) verwendet werden.

14. Verfahren nach einem der Ansprüche 10 bis 13, bei dem zur Decodierung eines empfangenen Blocks $2 \cdot w$-1 mal Zuverlässigkeitswerte ($L^{(i)}$) für diesen Block bestimmt werden, mit $w$ einer ganzen Zahl größer als 1,
wobei das Ergebnis der $2 \cdot w$-1 -ten Bestimmung als Decodierergebnis für diesen Block verwendet wird.

15. Codiervorrichtung zur Codierung von Informationen, mit
Mitteln zum Aufteilen von zu codierenden Bits in aufeinanderfolgende erste Blöcke ($u_e^{(i)}$),
Mitteln ($\pi$) zum Ermitteln von zweiten Blöcken ($u_o^{(i)}$) jeweils durch Permutation eines ersten Blocks ($u_e^{(i)}$), Mitteln (MUX1) zum Ermitteln von dritten Blöcken ($u^{(i)}$), indem jeweils ein erster Block ($u_e^{(i)}$) mit jeweils einem zweiten Block ($u_o^{(i)}$) verschachtelt wird,
Mitteln (TCM) zum Anwenden einer Faltungscodierung auf die dritten Blöcke ($u^{(i)}$), und
Mitteln (TCM) zum Zusammenfassen der Bits nach der Faltungscodierung zu Symbolen ($x^{(i)}$).

16. Codiervorrichtung nach Anspruch 15, wobei
pro erstem Block ($u_e^{(i)}$) nach der Faltungscodierung und der Zusammenfassung zu Symbolen ($x^{(i)}$) ein ganzzahliges Vielfaches von n-Tupeln von Symbolen ($x^{(i)}$) mit n einer ganzen Zahl größer als oder gleich 1 vorliegt, und
wobei die Codiervorrichtung Mittel (DEMUX1) zum Ausscheiden von jedem zweiten n-Tupel aufweist, so dass lediglich jedes zweite n-Tupel als Codierergebnis verwendet wird.

17. Decodiervorrichtung mit Mitteln zum Empfangen und Decodieren von nach einem der Ansprüche 1 bis 9 codierten Informationen, umfassend
Mittel (TCM DEC) zum Bestimmen von Zuverlässigkeitswerten ($L^{(i)}$) für empfangene Blöcke unter Verwendung eines iterativen Decodier-Algorithmus, bei welchem für einen Block bestimmte Zuverlässigkeitswerte ($L^{(i)}$) für die wiederholte Bestimmung von Zuverlässigkeitswerten ($L^{(i)}$) eines anderen Blocks verwendet werden.

## FIG 1

CONENC — MAP (TCM)

$$u \rightarrow \boxed{\text{CONENC}} \xrightarrow{v} \boxed{\text{MAP}} \xrightarrow{x}$$

## FIG 2

$$u_e^{(i-1)} \rightarrow \boxed{\pi}$$

$$u_o^{(i)}$$
$$u_e^{(i)} \rightarrow \boxed{\text{MUX1}} \xrightarrow{u^{(i)}} \boxed{\text{TCM}} \xrightarrow{x^{(i)}} \boxed{\text{DEMUX1}} \begin{array}{l} x_o^{(i)} \rightarrow \times \\ x_e^{(i)} \rightarrow \end{array}$$

## FIG 3

$$y^{(i)}, "0" \rightarrow \boxed{\text{MUX2}}$$
$$a_e^{(i)}, a_o^{(i)} \rightarrow \boxed{\text{MUX3}} \xrightarrow{a^{(i)}} \boxed{\begin{array}{c}\text{TCM}\\\text{DEC}\end{array}} \rightarrow \oplus \xrightarrow{L^{(i)}} \boxed{\text{DEMUX2}}$$

$$a_e^{(i-1)} \leftarrow \boxed{\pi^{-1}} \quad L_o^{(i)}$$
$$a_o^{(i+1)} \leftarrow \boxed{\pi} \quad L_e^{(i)}$$

**Europäisches Patentamt**

**EUROPÄISCHER RECHERCHENBERICHT**

Nummer der Anmeldung

EP 06 00 4038

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | HUEBNER A ET AL: "Laminated turbo codes" INFORMATION THEORY, 2005. ISIT 2005. PROCEEDINGS. INTERNATIONAL SYMPOSIUM ON ADELAIDE, AUSTRALIA 4-9 SEPT. 2005, PISCATAWAY, NJ, USA,IEEE, 4. September 2005 (2005-09-04), Seiten 597-601, XP010846420 ISBN: 0-7803-9151-9 * Abbildung 1 * * Seite 2, Spalte 2 * ----- | 1-17 | INV. H03M13/25 H03M13/37 H03M13/45 H03M13/23 |
| A | BENEDETTO S ET AL: "Self-concatenated codes with self-iterative decoding for power and bandwidth efficiency" INFORMATION THEORY, 1998. PROCEEDINGS. 1998 IEEE INTERNATIONAL SYMPOSIUM ON CAMBRIDGE, MA, USA 16-21 AUG. 1998, NEW YORK, NY, USA,IEEE, US, 16. August 1998 (1998-08-16), Seite 177, XP010296997 ISBN: 0-7803-5000-6 * das ganze Dokument * ----- | 1-17 | |
| P,A | AXEL HOF, MARTIN BOSSERT: "Staggered Trellis Coded Modulation" INTERNET ARTICLE, [Online] 7. April 2006 (2006-04-07), XP002378749 Gefunden im Internet: URL:http://tait.e-technik.uni-ulm.de/~hof/publications/tcrt06.pdf> [gefunden am 2006-04-26] * das ganze Dokument * ----- | 1-17 | **RECHERCHIERTE SACHGEBIETE (IPC)** H03M |

-/--

Der vorliegende Recherchenbericht wurde für alle Patentansprüche erstellt

| Recherchenort | Abschlußdatum der Recherche | Prüfer |
|---|---|---|
| Den Haag | 27. April 2006 | Rydyger, K |

EPO FORM 1503 03.82 (P04C03)

Europäisches
Patentamt

**EUROPÄISCHER RECHERCHENBERICHT**

Nummer der Anmeldung

EP 06 00 4038

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | SHANG-CHIH MA ET AL: "An enhanced block-coded modulation scheme with interblock memory" WIRELESS AND MOBILE COMPUTING, NETWORKING AND COMMUNICATIONS, 2005. (WIMOB'2005), IEEE INTERNATIONAL CONFERENCE ON MONTREAL, CANADA AUG. 22-24, 2005, PISCATAWAY, NJ, USA,IEEE, 22. August 2005 (2005-08-22), Seiten 171-173, XP010838803 ISBN: 0-7803-9181-0 * das ganze Dokument * ----- | 1-17 | |
| D,A | OGIWARA H ET AL: "IMPROVEMENT OF TURBO TRELLIS-CODED MODULATION SYSTEM" IEICE TRANSACTIONS ON FUNDAMENTALS OF ELECTRONICS, COMMUNICATIONS AND COMPUTER SCIENCES, ENGINEERING SCIENCES SOCIETY, TOKYO, JP, Bd. E81-A, Nr. 10, Oktober 1998 (1998-10), Seiten 2040-2046, XP009040113 ISSN: 0916-8508 * das ganze Dokument * ----- | 1-17 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Den Haag | 27. April 2006 | Rydyger, K |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
..............................................................................
& : Mitglied der gleichen Patentfamilie, übereinstimmendes
    Dokument

EPO FORM 1503 03.82 (P04C03)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **G. UNGERBOECK.** Channel coding with multilevel phase signals. *IEEE Transactions on Information Theory,* Januar 1982, vol. 28, 55-67
- **P. ROBERTSON ; T. WOERZ.** Bandwidth-efficient turbo trellis-coded modulation using punctured component codes. *IEEE Journal on Selected Areas in Communications,* Februar 1998, vol. 18, 206-218
- **H. OGIWARA.** Improvement of Turbo Trellis-Coded Modulation System. *IEICE Trans. Fundamentals,* Oktober 1998, vol. E81-A (10), 2040-2046